(19) Europäisches Patentamt
European Patent Office
Office européen des brevets

(11) **EP 4 095 505 B1**

(12) **EUROPÄISCHE PATENTSCHRIFT**

(45) Veröffentlichungstag und Bekanntmachung des Hinweises auf die Patenterteilung:
**15.04.2026 Patentblatt 2026/16**

(21) Anmeldenummer: **22174035.0**

(22) Anmeldetag: **18.05.2022**

(51) Internationale Patentklassifikation (IPC):
**G01M 11/02** (2006.01)

(52) Gemeinsame Patentklassifikation (CPC):
**G01M 11/0264**

(54) **VERFAHREN ZUR BESTIMMUNG EINER ABBILDUNGSQUALITÄT EINES OPTISCHEN SYSTEMS BEI BELEUCHTUNG MIT BELEUCHTUNGSLICHT INNERHALB EINER ZU VERMESSENDEN PUPILLE**

METHOD FOR DETERMINING THE IMAGING QUALITY OF AN OPTICAL SYSTEM UPON ILLUMINATION WITH ILLUMINATION LIGHT WITHIN A PUPIL TO BE MEASURED

PROCÉDÉ DE DÉTERMINATION D'UNE QUALITÉ D'IMAGE D'UN SYSTÈME OPTIQUE LORS DE L'ÉCLAIRAGE PAR LUMIÈRE D'ÉCLAIRAGE À L'INTÉRIEUR D'UNE PUPILLE À MESURER

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.05.2021 DE 102021205328**

(43) Veröffentlichungstag der Anmeldung:
**30.11.2022 Patentblatt 2022/48**

(73) Patentinhaber: **Carl Zeiss SMT GmbH**
**73447 Oberkochen (DE)**

(72) Erfinder:
• **Koch, Markus**
**89231 Neu-Ulm (DE)**

• **Capelli, Renzo**
**89522 Heidenheim (DE)**
• **Gwosch, Klaus**
**73431 Aalen (DE)**
• **Simakov, Dmitry**
**07745 Jena (DE)**

(74) Vertreter: **Rau, Schneck & Hübner**
**Patentanwälte Rechtsanwälte PartGmbB**
**Königstraße 2**
**90402 Nürnberg (DE)**

(56) Entgegenhaltungen:
**WO-A1-2015/044362      DE-A1- 10 317 366**
**US-A1- 2019 391 087**

## Beschreibung

Die Erfindung betrifft ein Verfahren zur Bestimmung einer Abbildungsqualität eines optischen Systems bei Beleuchtung mit Beleuchtungslicht innerhalb einer zu vermessenden Pupille des optischen Systems. Ferner betrifft die Erfindung ein Metrologiesystem zur Durchführung eines derartigen Verfahrens. Alternativ oder zusätzlich zur Bestimmung der Abbildungsqualität ermöglicht das beschriebene Verfahren die Qualifizierung der Wirkung der Teststruktur auf die Phase des Lichtes.

Ein derartiges Verfahren sowie ein Metrologiesystem hierfür sind bekannt aus der DE 10 2019 215 800 A1. Ein Metrologiesystem zum dreidimensionalen Vermessen eines Luftbildes einer Lithografiemaske ist bekannt aus der WO 2016/012 426 A1. Die DE 10 2013 219 524 A1 beschreibt eine Einrichtung und ein Verfahren zur Bestimmung einer Abbildungsgüte eines optischen Systems sowie ein optisches System. In der DE 10 2013 219 524 A1 ist ein Phase-Retrieval-Verfahren zur Bestimmung einer Wellenfront auf Grundlage der Abbildung eines Pinholes beschrieben. Aus dem Fachartikel von Martin et al., A new system for a wafer lever CD metrology on photomasks, proceedings of SPIE - The International Society for Optical Engineering, 2009, 7272, ist ein Metrologiesystem für die Bestimmung einer kritischen Dimension (CD) auf Waferebene bekannt. Die DE 10 2017 216 703 A1 offenbart ein Verfahren zur Charakterisierung mindestens einer optischen Komponente einer Projektionsbelichtungsanlage. Die DE 10 2019 215 800 A1 offenbart ein Verfahren zur Bestimmung einer optischen Phasendifferenz von Messlicht mit einer Messwellenlänge über eine Oberfläche eines strukturierten Objekts. Die DE 10 2018 211 895 A1 offenbart ein Verfahren zum Vermessen einer Inspektionsvorrichtung. Die DE 103 17 366 A1 offenbart ein Verfahren zur Bestimmung der Transmission einer Linse. Die WO 2015/044362 A1 offenbart eine Einrichtung und ein Verfahren zur Bestimmung einer Abbildungsgüte eines optischen Systems sowie ein optisches System mit mindestens einem Mittel zur Variierung einer Beleuchtungsverteilung in einer Pupille. Die US 2019/0391087 A1 offenbart ein Verfahren zur Detektion einer Struktur einer Lithografiemaske sowie eine dieses Verfahren durchführende Vorrichtung.

Es ist eine Aufgabe der vorliegenden Erfindung, ein Verfahren zur Abbildungsqualitätsbestimmung eines optischen Systems zu verbessern.

Diese Aufgabe ist erfindungsgemäß gelöst durch ein Bestimmungsverfahren mit den im Anspruch 1 angegebenen Merkmalen.

Erfindungsgemäß wurde erkannt, dass durch Einsatz einer periodischen Teststruktur für die Ermittlung eines Abbildungsbeitrages des optischen Systems und/oder für die Qualifizierung der Wirkung der Teststruktur auf die Phase des Lichts Randbedingungen erzeugt werden, die je nach Ausgestaltung des Bestimmungsverfahrens entweder die Genauigkeit der Abbildungsqualitätsbestimmung erhöhen oder die Geschwindigkeit der Abbildungsqualitätsbestimmung erhöhen. Bei der zu vermessenden Pupille kann es sich um eine Austrittspupille des optischen Systems und insbesondere um die Austrittspupille einer Projektionsoptik handeln. Zur Qualifizierung der Wirkung der Teststruktur auf die Phase des Lichts kann ein komplexes Maskenspektrum bestimmt werden. Die Teststruktur kann längs genau einer Dimension periodisch sein (1D Teststruktur). Alternativ kann die Teststruktur auch in mehr als einer Dimension, beispielsweise in zwei Dimensionen periodisch sein (2D Teststruktur).

Weitere Randbedingungen, die das Bestimmungsverfahren hinsichtlich seiner Genauigkeit und/oder hinsichtlich seiner Geschwindigkeit verbessern, ergeben sich durch die Vorgabe von Beleuchtungswinkelverteilungen mit im Vergleich zur Pupille kleinem Pupillenbereich. Die Fläche dieses Pupillenbereichs kann kleiner sein als 5 % der gesamten Pupillenfläche und kann beispielsweise höchstens 4 % der gesamten Pupillenfläche betragen. Regelmäßig ist die Fläche des Pupillenbereichs größer als 0,001 % der gesamten Pupillenfläche der Pupille.

Durch die Verwendung einer entsprechend hinsichtlich ihrer Richtung gut definierten Beleuchtung der Teststruktur kann sichergestellt werden, dass beispielsweise Beugungseffekte an der Teststruktur von Abbildungseffekten des zu vermessenden optischen Systems getrennt werden können.

Außer der Kenntnis von der Periodizität der Teststruktur, insbesondere der Kenntnis der Strukturperiode, sind zur Durchführung des Bestimmungsverfahrens keine weiteren Vorkenntnisse über die Teststruktur erforderlich. Die Periode kann wiederum innerhalb des Bestimmungsverfahrens durch bekannte Beugungs-Messschritte ermittelt werden.

Eine Projektionsoptik zur Abbildung eines Objektfeldes in der Objektebene in ein Bildfeld in der Bildebene kann das optische System darstellen, dessen Abbildungsqualität bestimmt werden soll, oder Bestandteil eines derartigen optischen Systems sein.

Das Bestimmungsverfahren kann beispielsweise zur Bestimmung eines Phasenunterschiedes zwischen einem Absorber und einem Multilayer einer Lithografiemaske aus dem Beugungsspektrum der Maske genutzt werden.

Eine entsprechende Phasenunterschied-Bestimmung ist beschrieben in der DE 10 2019 215 800 A1 und in der WO 2008 025 433 A2. Basierend auf der bestimmten Abbildungsqualität kann dann die Justage und/oder die Korrektur des optischen Systems erfolgen. Eine weitere Anwendung für die bestimmte Abbildungsqualität ist eine synthetische Berechnung von Luftbilder in einem Photoresist einer Maske, vgl. WO 2017 207 297 A1. Eine weitere Anwendung ist die Berechnung eines sogenannten Optical-Proximity Correction Modells. Hierzu wird verwiesen auf die DE 10 2016 218 977 A.

Bei der Erfassung der Intensität wird ein Messspektrum als durch das optische System geführtes Beugungsspektrum der periodischen Teststruktur erfasst. Diese Erfassung eines Messspektrums beinhaltet die Erfassung von Informationen zum reinen Beugungsspektrum der periodischen Teststruktur sowie zu einer Transferfunktion des optischen Systems. Dies kann im Bestimmungsverfahren dazu genutzt werden, Anteile des reinen Beugungsspektrums der periodischen Teststruktur vom erfassten Messspektrum zu separieren, sodass die Transferfunktion des optischen Systems und damit der Abbildungsbeitrag des optischen Systems verbleibt. Ein Zentrum des weiteren Pupillenbereichs ist von einem Zentrum des initialen Pupillenbereichs um genau eine Beugungsordnung eines Beugungsspektrums der Teststruktur beabstandet. Eine derartige Vorgabe der Beleuchtungswinkelverteilungen vereinfacht das Bestimmungsverfahren. Bei mehreren Wiederholungen der Vorgabe jeweils einer weiteren Beleuchtungswinkelverteilung können alle jeweiligen Pupillenbereiche jeweils um genau eine Beugungsordnung des Beugungsspektrums des jeweils benachbarten Pupillenbereichs beabstandet sein. Bei Nutzung einer 2D Teststruktur kann der Abstand um jeweils genau eine Beugungsordnung oder um ein ganzzahliges Vielfaches längs beider 2D-Koordinaten vorliegen.

Auch eine Beabstandung um ein ganzzahliges Vielfaches einer Beugungsordnung ist möglich.

Eine zumindest angenähert kreisförmige Pupille und/oder ein zumindest angenähert kreisförmiger Pupillenbereich oder ein elliptischer Pupillenbereich nach Anspruch 2 vereinfachen das Bestimmungsverfahren. Soweit die Pupille und/oder der Pupillenbereich von einer Kreisform abweichen, kann ein Radius der Pupille und/oder ein Radius des Pupillenbereichs als mittlerer Radius berechnet werden. Eine Obergrenze für den Radius des Pupillenbereichs, der die jeweilige Beleuchtungswinkelverteilung repräsentiert, kann 25 %, 20 %, 15 % oder auch 10 % eines Radius der Pupille sein oder auch noch kleiner sein.

Eine Wiederholung der Verfahrensschritte nach Anspruch 3 führt zu einer Verbesserung einer Genauigkeit des Bestimmungsverfahrens. Prinzipiell kann das Verfahren auch mit genau zwei Beleuchtungswinkelverteilungen durchgeführt werden, beispielsweise mit einer initialen Beleuchtungswinkelverteilung mit zentraler Beleuchtung der Pupille und mit genau einer gegenüber dieser initialen Beleuchtungswinkelverteilung verschobenen Beleuchtungswinkelverteilung.

Eine Abbildungsbeitrag-Ermittlung nach Anspruch 5 vereinfacht das Bestimmungsverfahren. Eine derartige reine Verschiebung eines Beugungsspektrums in der Pupille ist im Zusammenhang mit der Hopkins-Näherung bekannt. Hierzu wird auch auf die US 2019/0391087 A1 sowie die dort angegebenen Referenzen verwiesen.

Beim Bestimmungsverfahren nach Anspruch 6 ergibt sich eine weitere Vereinfachung.

Eine Rekonstruktion nach Anspruch 7 erhöht eine Qualität des Bestimmungsverfahrens.

Dies gilt besonders für ein Rekonstruktionsverfahren nach Anspruch 8. Eine Differenzminimierung zwischen einem gemessenen Luftbild und einem vom zu rekonstruierenden Messspektrum abhängigen Luftbild ist beschrieben in der DE 10 2019 215 800 A1.

Eine Rekonstruktion der Transferfunktion nach Anspruch 9 ermöglicht eine Auswertung beispielsweise einer Apodisierung des optischen Systems über die Amplitude der Transferfunktion oder eines Wellenfrontfehlers des optischen Systems über die Phase der Transferfunktion. Die Apodisierung und der Wellenfrontfehler sind Beispiele für den aus dem ermittelten Abbildungsbeitrag ermittelten Abbildungs-Qualitätsparameter. Bei der Ermittlung eines Abbildungsbeitrages zur Bestimmung der Abbildungsqualität kann eine Rekonstruktion eines Beugungsspektrums der periodischen Teststruktur erfolgen.

Eine Vorgabe eines Pupillenbereichs nach Anspruch 11 ermöglicht die Erfassung einer größtmöglichen Anzahl von Beugungsordnungen.

Eine Vorgabe der jeweiligen Beleuchtungswinkelverteilung nach Anspruch 12 hat sich in der Praxis bewährt. Die Blende kann in einer Pupillenebene einer Beleuchtungsoptik vor dem optischen System angeordnet sein.

Die Vorteile eines Metrologiesystems nach Anspruch 13 entsprechen denen, die vorstehend unter Bezugnahme auf das Bestimmungsverfahren bereits erläutert wurden. Wenn bei dem Metrologiesystem mithilfe des Bestimmungsverfahrens die Abbildungsqualität des optischen Systems bestimmt ist, kann das Metrologiesystem im Anschluss hieran zur Bestimmung einer Struktur einer hinsichtlich ihrer Struktur noch unbekannten und beispielsweise unperiodischen Teststruktur herangezogen werden, da dann die Abbildungsqualität bestimmt ist und eine Separierung einer Apparatefunktion des Metrologiesystems von den Struktureinflüssen der Teststruktur möglich ist.

Die Vorteile der Vorgabeeinrichtung des Metrologiesystems entsprechen denen, die vorstehend im Zusammenhang mit dem Bestimmungsverfahren bereits erläutert wurden. Eine Öffnung der Blende kann variabel vorgebbar sein, beispielsweise nach Art einer Irisblende. Die Blende kann in mindestens einer lateralen Richtung verlagerbar sein. Die Blende kann beispielsweise in zwei zueinander senkrecht stehenden lateralen Richtungen verlagerbar sein, was insbesondere beim Einsatz einer 2D Teststruktur sinnvoll ist.

Eine Lichtquelle nach Anspruch 14 kann als EUV-Lichtquelle ausgeführt sein. Eine EUV-Wellenlänge der Lichtquelle kann im Bereich zwischen 5 nm und 30 nm liegen. Auch eine Lichtquelle im DUV-Wellenlängenbereich, beispielsweise im Bereich von 193 nm, ist möglich.

Ausführungsbeispiele der Erfindung werden nachfolgend anhand der Zeichnungen erläutert. In dieser zeigen:

Fig. 1    stark schematisch in einer Seitenansicht ein Metrologiesystem zur Bestimmung einer Abbildungsqualität eines optischen Systems bei Beleuchtung mit Beleuchtungslicht innerhalb einer zu vermessenden Pupille des optischen Systems, aufweisend eine Beleuchtungsoptik und eine abbildende Optik, die jeweils stark schematisch dargestellt sind;

Fig. 2    eine Aufsicht auf eine binäre, periodische Teststruktur, angeordnet bei II im Metrologiesystem nach Fig. 1;

Fig. 3    ebenfalls in einer Aufsicht entsprechend Fig. 2 eine Feldverteilung eines elektromagnetischen Feldes des Beleuchtungslichts im Beleuchtungslicht-Strahlengang bei III in Fig. 1 nach Beaufschlagung der Teststruktur;

Fig. 4    wiederum in einer Aufsicht nach Fig. 2 ein Beugungsspektrum der Teststruktur im Beleuchtungslicht-Strahlengang bei IV in Fig. 1;

Fig. 5    in einer zu Fig. 4 ähnlichen Darstellung das aufgrund einer Aperturblende bei V in Fig. 1 des Metrologiesystems randseitig beschnittene Beugungsspektrum;

Fig. 6    in einer zu Fig. 5 ähnlichen Darstellung das Beugungsspektrum einschließlich als Höhenlinien angedeuteten Wellenfront-Einflüssen durch die abbildende Optik des Metrologiesystems als Messspektrum im Bereich einer Austrittspupille der abbildenden Optik bei VI in Fig. 1;

Fig. 7    in einer zu Fig. 3 ähnlichen Aufsicht eine komplexe Feldverteilung des Beleuchtungslichts bei Beaufschlagung einer ortsauflösenden Detektionseinrichtung des Metrologiesystems im Beleuchtunglicht-Strahlengang bei VII in Fig. 1;

Fig. 8    in einer zu Fig. 7 ähnlichen Darstellung eine von der Detektionseinrichtung gemessene Beleuchtungslicht-Intensität am Ort der Detektionseinrichtung bei VIII in Fig. 1;

Fig. 9    in einer zu Fig. 6 ähnlichen Darstellung eine Messsituation des Metrologiesystems mit einer initialen Beleuchtungswinkelverteilung bei zentrierter Beleuchtung der Teststruktur, vorgegeben durch einen kleinen, zentrierten initialen Pupillenbereich, wobei eine 0. Beugungsordnung der Teststruktur mittig in dem initialen Pupillenbereich und in einem durch die Aperturblende vorgegebenen Zentrum der Pupille des Metrologiesystems liegt, wobei in der Fig. 9 auch Beugungsordnungen jenseits eines Beschnitts durch die Aperturblende dargestellt sind;

Fig. 10    in einer zu Fig. 9 ähnlichen Darstellung eine weitere Messsituation des Metrologiesystems mit einer weiteren Beleuchtungswinkelverteilung, bei der der initiale Pupillenbereich und damit die 0. Beugungsordnung des von der Teststruktur gebeugten Beleuchtungslichts so verschoben ist, dass sie nun an den Ort einer -1. Beugungsordnung der Messsituation nach Fig. 9 verschoben ist;

Fig. 11    in einer zu Fig. 9 ähnlichen Darstellung eine weitere Messsituation des Metrologiesystems mit einer weiteren Beleuchtungswinkelverteilung, bei der der initiale Pupillenbereich und damit die 0. Beugungsordnung des von der Teststruktur gebeugten Beleuchtungslichts so verschoben ist, dass sie nun an den Ort einer +1. Beugungsordnung der Messsituation nach Fig. 9 verschoben ist;

Fig. 12    in einer zu Fig. 1 ähnlichen Darstellung das Metrologiesystem, wobei zusätzliche, verschiedene Messsituationen vorgebende Freiheitsgerade für Komponenten des Metrologiesys-tems dargestellt sind;

Fig. 13    in einer zu Fig. 9 ähnlichen Darstellung bei einer initialen Messsituation das Beugungsspektrum einer zweidimensionalen binären periodischen Teststruktur, wobei eine initiale Beleuchtungswinkelverteilung so gewählt ist, dass eine von dem initialen Pupillenbereich vorgegebene 0. Beugungsordnung der Teststruktur zentrisch in einer von der Aperturblende vorgegebenen Pupille des Metrologiesystems liegt;

Fig. 14    in einer zu Fig. 10 ähnlichen Darstellung das Beugungsspektrum nach Fig. 13 bei einer weiteren Messsituation mit einer Beleuchtungswinkelverteilung, bei der der initiale Pupillenbereich und damit die 0. Beugungsordnung in horizontaler Richtung an den Ort der -1. Beugungsordnung nach Fig. 13 verschoben ist;

Fig. 15    in einer zu den Fig. 13 und 14 ähnlichen Darstellung das Beugungsspektrum bei einer weiteren Messsituation mit einer weiteren Beleuchtungswinkelverteilung, bei der das Beugungsspektrum der zweidimensionalen Teststruktur so in ver- tikaler Richtung verschoben ist, dass der initiale Pupillenbereich und damit die 0. Beugungsordnung am Ort der +1. Beugungsordnung in vertikaler Richtung liegt.

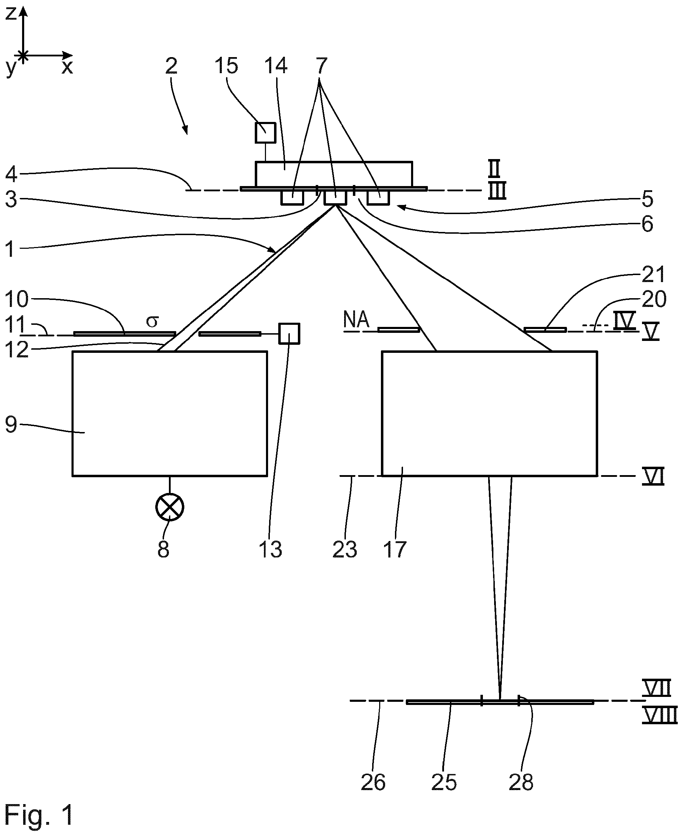

Zur Erleichterung der Darstellung von Lagebeziehungen wird nachfolgend ein kartesisches xyz-Koordinatensystem verwendet. Die x-Achse verläuft in der Fig. 1 horizontal nach rechts. Die y-Achse verläuft in der Fig. 1 senkrecht zur Zeichenebene in diese hinein. Die z-Achse verläuft in der Fig. 1 vertikal nach oben.

Fig. 1 zeigt in einer einem Meridionalschnitt entsprechenden Ansicht einen Strahlengang von EUV-Beleuchtungslicht bzw. Abbildungslicht 1 in einem Metrologiesystem 2 zur Bestimmung einer Abbildungsqualität eines optischen Systems bei Beleuchtung mit dem Beleuchtungslicht 1 innerhalb einer zu vermessenden Pupille. Abgebildet wird hierbei eine in einem Objektfeld 3 in einer Objektebene 4 angeordnete Teststruktur 5.

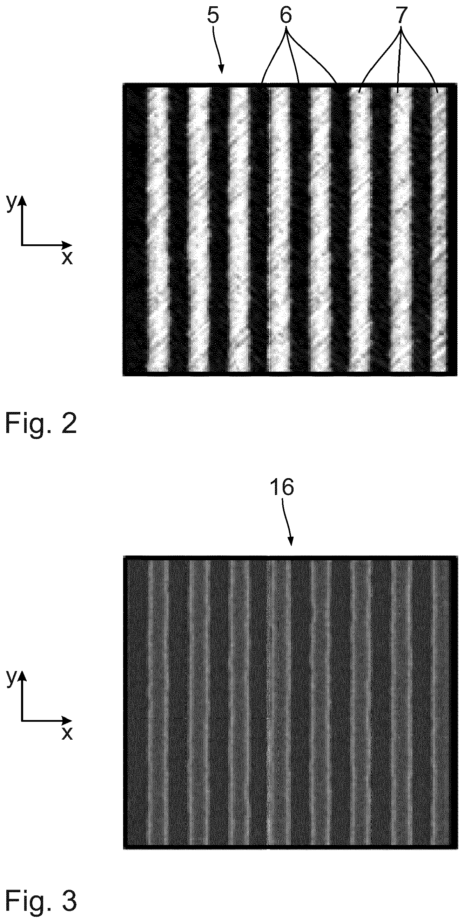

Die Teststruktur 5 ist in einer Aufsicht in der Fig. 2 dargestellt. Die Teststruktur 5 ist in einer Dimension, nämlich längs der x-Koordinate, periodisch. Die Teststruktur 5 ist als binäre Teststruktur mit Absorberlinien 6 und jeweils alternierenden, für das Beleuchtungslicht 1 reflektierenden Multilayer-Linien 7 ausgeführt. Bei den Linien 6, 7 handelt es sich um vertikale Strukturen.

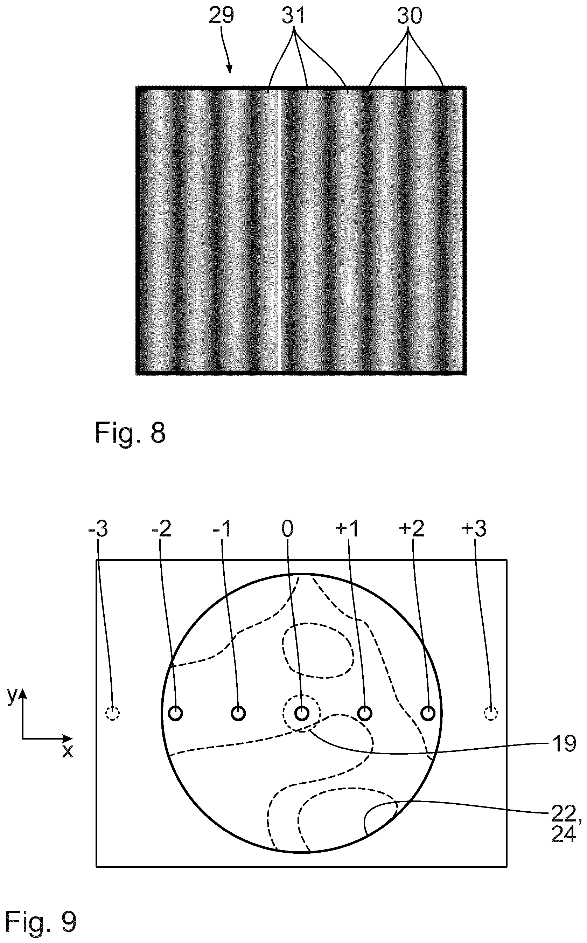

Das Metrologiesystem 2 wird zur Analyse eines dreidimensionalen (3D-) Luftbildes (Aerial Image Metrology System) eingesetzt. Anwendungsfälle sind die Nachbildung eines Luftbildes (Aerial Image) einer Lithografiemaske so, wie das Luftbild auch in einer produzierenden Projektionsbelichtungsanlage, zum Beispiel in einem Scanner, aussehen würde. Hierzu muss insbesondere eine Abbildungsqualität des Metrologiesystems 2 selbst vermessen und gegebenenfalls justiert werden. Die Analyse des Luftbildes kann somit zur Bestimmung der Abbildungsqualität einer Projektionsoptik des Metrologiesystems 2 oder auch zur Bestimmung der Abbildungsqualität insbesondere von Projektionsoptiken innerhalb einer Projektionsbelichtungsanlage dienen. Metrologiesysteme sind aus der WO 2016/012 426 A1, aus der US 2013/0063716 A1 (vgl. dort Figur 3), aus der DE 102 20 815 A1 (vgl. dort Figur 9), aus der DE 102 20 816 A1 (vgl. dort Figur 2) und aus der US 2013/0083321 A1 bekannt.

Das Beleuchtungslicht 1 wird an der Teststruktur 5 reflektiert und gebeugt. Eine Einfallsebene des Beleuchtungslichts 1 liegt bei mittiger, initialer Beleuchtung parallel zur xz-Ebene.

Das EUV-Beleuchtungslicht 1 wird von einer EUV-Lichtquelle 8 erzeugt. Bei der Lichtquelle 8 kann es sich um eine Laser-Plasma-Quelle (LPP; laser produced plasma) oder um eine Entladungsquelle (DPP; discharge produced plasma) handeln. Grundsätzlich kann auch eine Synchrotron-basierende Lichtquelle zum Einsatz kommen, z. B. ein Freie-Elektronen-Laser (FEL). Eine Nutzwellenlänge der EUV-Lichtquelle kann im Bereich zwischen 5 nm und 30 nm liegen. Grundsätzlich kann bei einer Variante des Metrologiesystems 2 auch eine Lichtquelle für eine andere Nutzlichtwellenlänge anstelle der Lichtquelle 8 zum Einsatz kommen, beispielsweise eine Lichtquelle für eine Nutzwellenlänge von 193 nm.

Zwischen der Lichtquelle 8 und der Teststruktur 5 ist eine Beleuchtungsoptik 9 des Metrologiesystems 2 angeordnet. Die Beleuchtungsoptik 9 dient zur Beleuchtung der zu untersuchenden Teststruktur 5 mit einer definierten Beleuchtungsintensitätsverteilung über das Objektfeld 3 und gleichzeitig mit einer definierten Beleuchtungswinkelverteilung, mit der die Feldpunkte des Objektfelds 3 beleuchtet werden. Eine derartige Beleuchtungswinkel-verteilung wird auch als Beleuchtungssetting bezeichnet.

Die jeweilige Beleuchtungswinkelverteilung des Beleuchtungslichts 1 wird über eine Vorgabeeinrichtung 10 vorgegeben, die in einer Beleuchtungsoptik-Pupillenebene 11 angeordnet ist. Die Vorgabeeinrichtung 10 ist als Aperturblende ausgeführt, die ein hierauf einfallendes Bündel des Beleuchtungslichts 1 randseitig begrenzt. Die aufgrund dieser Begrenzung resultierende Beleuchtungswinkelverteilung ist durch einen zusammenhängenden, ausgeleuchteten Pupillenbereich repräsentiert, dessen Fläche kleiner ist als 10 % einer gesamten Pupillenfläche der genutzten Pupille des optischen Systems des Metrologiesystems 2.

Wenn beispielsweise die genutzte Pupille einen normierten Durchmesser von 1 hat, kann ein Durchmesser der von der Vorgabeeinrichtung 10 vorgegebenen Beleuchtungswinkelverteilung in einer nachfolgenden Pupillenebene des optischen Systems des Metrologiesystems 2 höchstens 0,2 betragen. In diesem Fall ist die Fläche des ausgeleuchteten Pupillenbereichs höchstens 4 % der gesamten Pupillenfläche.

Die Vorgabeeinrichtung 10 ist als angetrieben verlagerbare Blende in einem Beleuchtungslicht-Strahlengang 12 des Beleuchtungslichts 1 vor der Objektebene 4 ausgeführt. Eine zur angetriebenen Verlagerung der Vorgabeeinrichtung 10 eingesetzte Antriebseinheit ist in der Fig. 1 bei 13 dargestellt. Mit der Antriebseinheit 13 kann die Vorgabeeinrichtung längs der x-Koordinate und/oder längs der y-Koordinate verlagert werden. Auch eine Feineinstellung längs der z-Koordinate zur Justierung einer Übereinstimmung einer Anordnungsebene der Vorgabeeinrichtung 10 relativ zur Beleuchtungsoptik-Pupillenebene 11 ist möglich. Die Antriebseinheit 13 kann zudem so ausgeführt sein, dass eine Verkippung der Blende um mindestens eine Kippachse parallel zur x-Achse und/oder parallel zur y-Achse möglich ist. Auch ein Durchmesser der Aperturblende der Vorgabeeinrichtung 10 kann einstellbar und insbesondere angetrieben vorggebbar sein.

Die Teststruktur 5 wird von einer Objekthalterung 14 des Metrologiesystems 2 gehalten. Die Objekthalterung 14 wirkt mit einem Objektverlagerungsantrieb 15 zur Verlagerung der Teststruktur 5 insbesondere längs der z-Koordinate zusammen.

Nach der Reflexion an der Teststruktur 5 liegt eine Verteilung 16 des elektromagnetischen Feldes des Beleuchtungslichts 1 vor, die in der Fig. 3 in einer der Fig. 2 entsprechenden Aufsicht dargestellt ist. In der Feldverteilung 16 entsprechen Amplituden und Phasenwerte den Absorberlinien 6 und den Multilayer-Linien 7 der Teststruktur 5.

Das von der Teststruktur 5 reflektierte Beleuchtungslicht 1 tritt in eine abbildende Optik bzw. Projektionsoptik 17 des Metrologiesystems 2 ein. Bei der Projektionsoptik 17 handelt es sich um das hinsichtlich seiner Abbildungsqualität zu untersuchende optische System des Metrologiesystems 2.

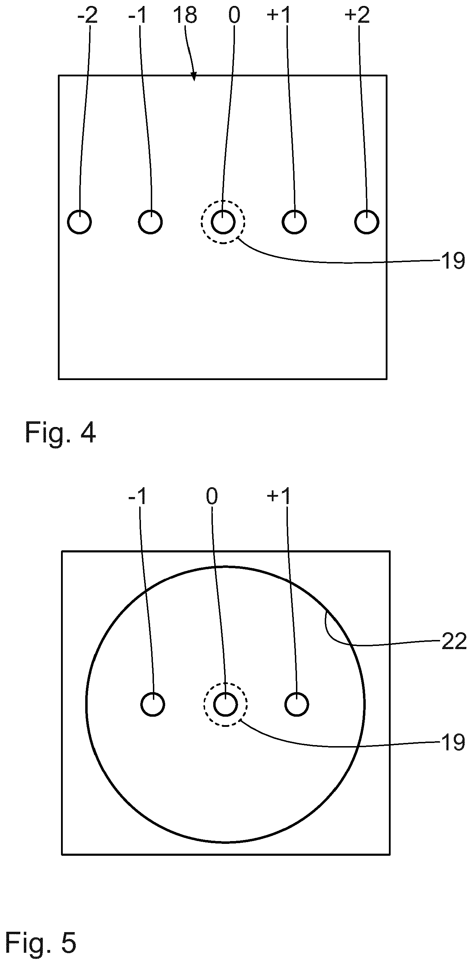

In einer Pupillenebene der Projektionsoptik 17 ergibt sich aufgrund der Periodizität der Teststruktur 5 ein Beugungsspektrum 18 (vgl. Fig. 4).

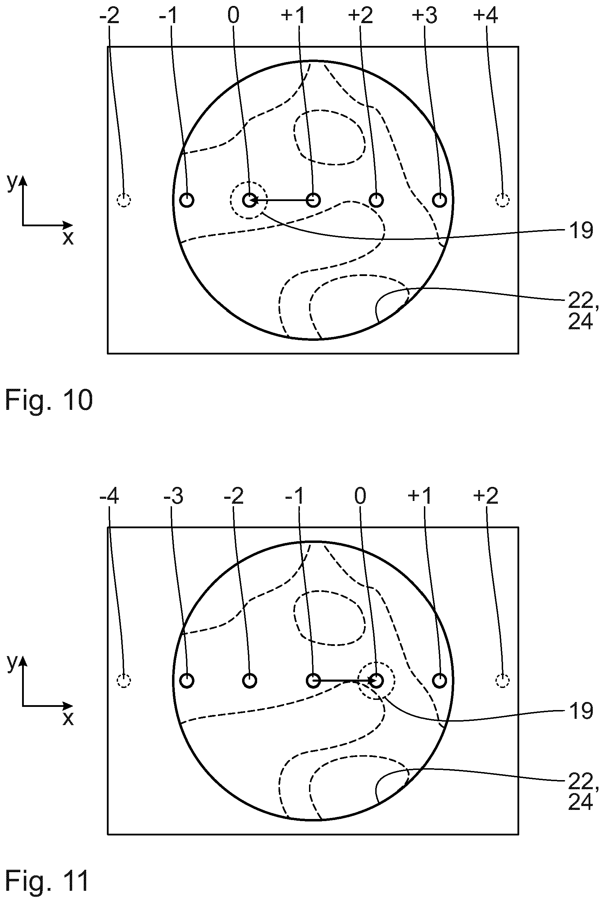

In der Fig. 4 ist zusätzlich zu den Beugungsordnungen des Beugungsspektrums 18 auch der sich aufgrund der initialen zentralen Beleuchtungswinkelverteilung des Metrologiesystems 2 ergebende initiale Pupillenbereich 19 dargestellt. Dieser initiale Pupillenbereich 19 entspricht hinsichtlich seiner Größe und Lage dem Pupillenbereich, der in der Beleuchtungsoptik-Pupillenebene 11, die zur Pupillenebene nach Fig. 11 konjugiert ist, durch die Vorgabeeinrichtung 10 vorgegeben wurde. Am Ort dieses vorgegebenen Pupillenbereichs 19 liegt im Beugungsspektrum 18 die 0. Beugungsordnung der Teststruktur 5 vor. Zudem sind in der Fig. 4 auch noch die +/-1. Beugungsordnung und die +/-2. Beugungsordnung des Beugungsspektrums 18 wiedergegeben.

Die Beugungsordnungen des Beugungsspektrums 18, die in der Fig. 4 dargestellt sind, zeigen sich in dieser Form in einer Pupillenebene des optischen Systems des Metrologiesystems 2, beispielsweise in einer Eintrittspupillenebene 20 der Projektionsoptik 17. In dieser Eintrittspupillenebene 20 ist eine Aperturblende 21 der Projektionsoptik 17 angeordnet, die eine Eintrittspupille 22 der Projektionsoptik 17 randseitig begrenzt.

Fig. 5 zeigt die Eintrittspupille 22 sowie die drei Beugungsordnungen des Beugungsspektrums 18, die bei der initialen Beleuchtungswinkelverteilung in der Eintrittspupille 22 liegen, nämlich die 0. sowie die +/-1. Beugungsordnung. Dargestellt ist in der Fig. 5 wiederum der initiale Pupillenbereich 19, der über die Vorgabeeinrichtung 10 zur Beleuchtung ausgewählt ist.

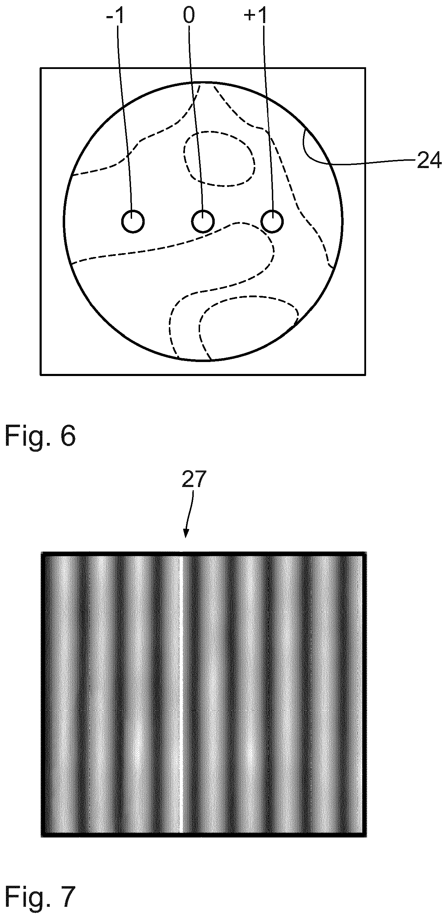

Fig. 6 zeigt eine Verteilung einer Intensität des Beleuchtungs-/Abbildungslichts 1 in einer Austrittspupillenebene der Beleuchtungsoptik 17. Eine in der Fig. 6 dargestellte Austrittspupille 24 ergibt sich als Bild der Eintrittspupille 22.

Die Pupillen 22 (vgl. Fig. 5) und 24 (vgl. Fig. 6) sind kreisförmig. Bei alternativen Vorgaben durch entsprechende Aperturblenden 21 können die Pupillen 22, 24 auch von der Kreisform abweichen, wobei die Pupillen zumindest angenähert kreisförmig sein können. Ein Pupillenradius kann in einem solchen Fall als mittlerer Radius berechnet werden. Beispielsweise können derartige alternative Pupillen elliptisch mit einem Aspektverhältnis zwischen den Halbachsen im Bereich zwischen 1 und beispielsweise 3 ausgeführt sein. Bei einer nicht figürlich dargestellten Ausführung können die Pupillen 22 und 24 auch elliptisch sein.

Der Pupillenbereich 19 ist ebenfalls kreisförmig oder elliptisch oder kann durch einen kreisförmigen Bereich angenähert werden. Die Beziehung $\sigma \leq 0{,}2$ bedeutet, dass ein Radius eines derartigen kreisförmigen Pupillenbereichs 19 höchstens 20 % eines Radius der Pupille 22, 24 beträgt.

Zur Intensitätsverteilung in der Austrittspupille 24 tragen einerseits die Bilder der -1., 0. und +1. Beugungsordnung bei und andererseits ein Abbildungsbeitrag des optischen Systems, nämlich der Projektionsoptik 17. Dieser Abbildungsbeitrag, der in der Fig. 6 durch gestrichelte Höhenlinien verdeutlicht ist, kann, wie nachfolgend noch erläutert wird, durch eine Transferfunktion des optischen Systems beschrieben werden. Unvermeidbare Abbildungsfehler des optischen Systems führen dazu, dass in der Austrittspupille 24 auch in Bereichen um die Beugungsordnungen eine messbare Intensität des Beleuchtungs-/Abbildungslichts 1 vorliegt.

Die Projektionsoptik 17 bildet die Teststruktur 5 hin zu einer ortsauflösenden Detektionseinrichtung 25 des Metrologiesystems 2 ab. Die Projektionsoptik 17 ist als vergrößernde Optik ausgeführt. Ein Vergrößerungsfaktor der Projektionsoptik 17 kann größer sein als 10, kann größer sein als 50, kann größer sein als 100 und kann auch noch größer sein. Im Regelfall ist dieser Vergrößerungsfaktor kleiner als 1.000.

Fig. 7 zeigt entsprechend der Fig. 3 eine komplexe Feldverteilung 27 des Beleuchtungs-/Abbildungslichts 1 im Bereich einer Bildebene 26, in der die Detektionseinrichtung 25 angeordnet ist.

Fig. 8 zeigt eine von der Kamera 25 in einem Bildfeld 28 gemessene Intensitätsverteilung 29 des Beleuchtungs-/Abbildungslichts 1. Bilder der Absorberlinien 6 sind in der Intensitätsverteilung 29 als im Wesentlichen dunkle Linien 30 geringer Intensität und Bilder der Multilayer-Linien 7 als helle Linien 31 größerer Intensität in der Intensitätsverteilung 29 vertreten.

Die Detektionseinrichtung 25 kann als CCD- oder als CMOS-Kamera ausgeführt sein.

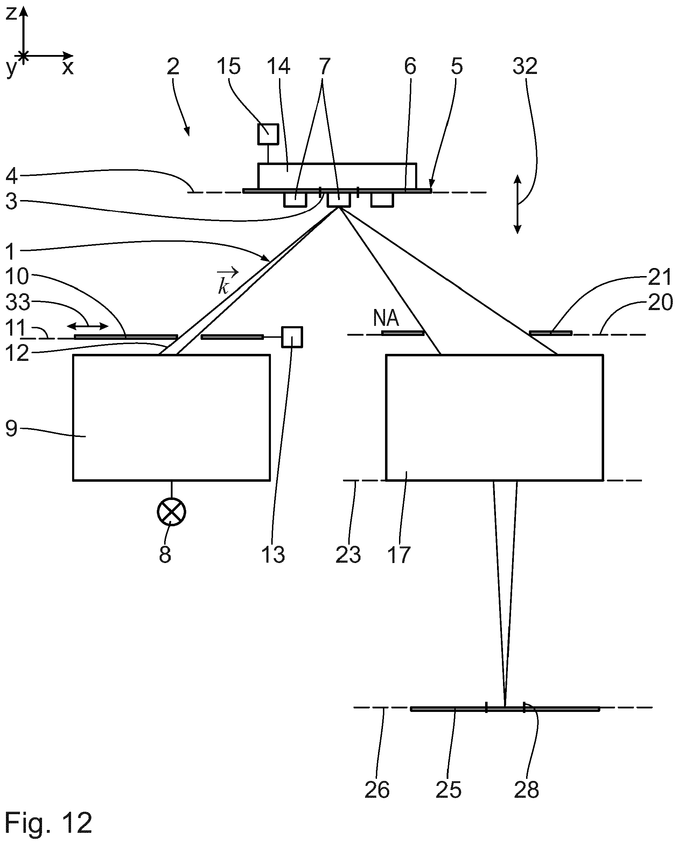

Fig. 12 verdeutlicht Freiheitsgrade, die bei einem Verfahren zur Bestimmung einer Abbildungsqualität des optischen Systems des Metrologiesystems 2 relevant sein können, nämlich eine z-Verlagerbarkeit (Doppelpfeil 32) der Teststruktur 5, die über eine Ansteuerung des in der Fig. 12 nicht dargestellten Objektverlagerungsantriebs herbeigeführt wird, und eine x/y-Verlagerbarkeit (Doppelpfeil 33) der Vorgabeeinrichtung 10 für die Beleuchtungswinkelverteilung zum Beleuchten der Teststruktur 5, die über eine Ansteuerung der in der Fig. 12 nicht dargestellten Antriebseinheit 13 herbeigeführt wird.

Über die Antriebseinheit 13 kann zudem eine Öffnungsweite der Blende der Vorgabeeinrichtung 10 variabel vorgebbar sein.

Fig. 12 zeigt zudem die über die Vorgabeeinrichtung 10 vorgegebene Rich-tung eines Hauptstrahls des Beleuchtungslichts 1 zur Teststruktur 5, wiedergegeben über einen Vektor $\vec{k}$.

Bei der nachfolgend noch näher erläuterten Bestimmung der Abbildungsqualität des optischen Systems des Metrologiesystems 2 wird aus einer Serie von gemessenen Intensitätsverteilungen nach Art der Intensitätsverteilung 29 nach Fig. 8, die unterschiedlichen z-Positionen der Teststruktur 5 entsprechen und insgesamt als Luftbild bezeichnet werden, und aus einer Serie derartiger Luftbilder eine Feldverteilung der Teststruktur 5, das Beugungsspektrum der Teststruktur 5, also die Fourier-Transformation der Objekt-Feldverteilung, eine Point-Spread-Funktion der Projektionsoptik 17 bzw. dessen Fourier-Transformation, eine komplexwertige Transferfunktion der Projektionsoptik 17, bestimmt.

Bei der Bestimmung der Abbildungsqualität des optischen Systems des Metrologiesystems 2 wird zunächst die Teststruktur 5 in der Objektebene 4 im Objektfeld 3 der Projektionsoptik 17 angeordnet, indem die Teststruktur 5 entsprechend mit der Objekthalterung 14 verbunden wird.

Anschließend wird mit der Vorgabeeinrichtung 10 die initiale Beleuchtungswinkelverteilung $\vec{k}_0$ entsprechend dem zentrierten Pupillenbereich 19 eingestellt. Diese initiale Beleuchtungswinkelverteilung beleuchtet die Teststruktur 5 mit dem Beleuchtungslicht 1 aus einer Beleuchtungsrichtung, die durch den initialen Pupillenbereich 19 repräsentiert ist. Die Fläche des Pupillenbereichs 19 ist kleiner als 10 % der gesamten Pupillenfläche der Eintrittspupille 22. Es gilt insbesondere für den Pupillenbereich 19: $\sigma < 0{,}2$.

Die Vorgabe der initialen Beleuchtungswinkelverteilung $\vec{k}_0$, also das Zentrieren der Beleuchtung, erfolgt so, dass (vgl. Fig. 12) ein Hauptstrahl des Beleuchtungslichts 1 mit einem Hauptstrahl eines Abbildungsstrahlengangs der Projektionsoptik 17 übereinstimmt. Es gilt dann definitionsgemäß: $\vec{k}_0 = (0{,}0)$ in einem entsprechenden Koordinatensystem der Pupillen 22, 24 der Projektionsoptik 17.

Nun wird die Teststruktur mit dieser initialen Beleuchtungswinkelverteilung in verschiedenen Abstandspositionen der Teststruktur 5 relativ zur Objektebene 4 mit dem Beleuchtungslicht 1 beleuchtet, also in verschiedenen z-Positionen der Teststruktur 5, die über die Objekthalterung 14 vorgegeben werden. Die Intensität des mit der Projektionsoptik 17 bei der Abbildung der Teststruktur 5 in jeder dieser z-Abstandspositionen geführten Beleuchtungslicht 1 wird in der Bildebene 26 der Projektionsoptik 17 mit der Detektionseinrichtung 25 zur Bestimmung eines initialen gemessenen Luftbildes der Teststruktur 5 erfasst. Diese z-Abstandsposition wird auch als Fokuslage bezeichnet. Es wird also ein Stapel von Intensitätsverteilungen entsprechend der Intensitätsverteilung 29 in den verschiedenen z-Positionen gemessen. Beispielsweise können neun verschiedene z-Positionen der Teststruktur 5 bei dieser Luftbildmessung eingestellt werden. Der hierbei genutzte z-Bereich kann mehrere Rayleigh-Einheiten (Rayleigh--Einheit = $0{,}5\ \lambda/\mathrm{NA}^2$, wobei $\lambda$ die Wellenlänge des Beleuchtungslichts ist und NA eine numerische Apertur der Beleuchtung) überstreichen.

Jede der bei einer z-Abstandsposition aufgenommenen Intensitätsverteilungen entsprechend der Intensitätsverteilung 29 kann geschrieben werden als $I(\vec{x}, z, \vec{k}_0)$.

$\vec{x}$ bezeichnet hierbei den jeweiligen x,y-Ortsvektor innerhalb der Intensitätsverteilung, also den Ort eines Detektorpixels der Projektionseinrichtung 25.

z bezeichnet die jeweilige z-Abstandsposition, bei der diese Intensitätsverteilung gemessen ist.

$\vec{k}_0$ bezeichnet die initiale Beleuchtungswinkelverteilung, bei der diese Messung durchgeführt wird.

Nun wird eine weitere Beleuchtungswinkelverteilung mit Hauptstrahlrichtung $\vec{k}_{-1}$ zum Beleuchten der Teststruk-tur 5 vorgegeben, indem die Blende der Vorgabeeinrichtung 10 verschoben wird. Diese Verschiebung ergibt sich durch einen Vergleich der Fig. 9 und 10. Diese Verschiebung ist entlang der x-Achse der Pupille 22, 24 der Projektionsoptik 17 so, dass der Pupillenbereich 19, in dem aufgrund der neuen Beleuchtungswinkelverteilung die Pupille 22, 24 ausgeleuchtet ist, nun am Ort der -1. Beugungsordnung der initialen Beleuchtungswinkelverteilung nach Fig. 9 zu liegen kommt. Es gilt also für die Beleuchtungsrichtung der nun vorgegebenen weiteren Beleuchtungswinkelverteilung:

$\vec{k}_{-1} = (-1/p, 0)$ in den x,y-Koordinaten der Pupille 22, 24. Hierbei sind

p = pitch/$\lambda$ mit pitch = Periode der Teststruktur 5 und $\lambda$ die Wellenlänge des Beleuchtung-/Abbildungslichts 1.

Ein Zentrum des nach der Verschiebung resultierenden Pupillenbereichs 19 nach Fig. 10 ist also um genau eine Beugungsordnung des Beugungsspektrums 18 vom Zentrum des initialen Pupillenbereichs 19 (vgl. Fig. 9) beabstandet.

Der Pupillenbereich 19 wird bei der Vorgabe dieser weiteren Beleuchtungswinkelverteilung so verschoben, dass er in der Pupille 22, 24 nicht mit dem initialen Pupillenbereich (vgl. die Position des Pupillenbereichs 19 in Fig. 9) überlappt.

Anschließend wird wiederum ein Luftbildstapel bei dieser weiteren Beleuchtungswinkelverteilung gemessen. Es wird also die Teststruktur 5 mit dieser weiteren Beleuchtungswinkelverteilung in verschiedenen z-Abstandspositionen der Teststruktur 5 relativ zur Objektebene 4 beleuchtet und die Intensität des entsprechend durch die Projektionsoptik 17 geführten Beleuchtungs-/Abbildungslicht 1 mit der ortsauflösenden Detektionseinrichtung 25 zur Bestimmung eines weiteren gemessenen Luftbildes in jeder z-Abstandsposition erfasst. Es wird also ein Luftbildstapel $I(\vec{x}, z, \vec{k}_{-1})$ gemessen.

Nun kann eine weitere Beleuchtungswinkelverteilung vorgegeben werden, wie in der Fig. 11 veranschaulicht, wobei dann der Pupillenbereich 19, der die mit der Vorgabeeinrichtung 10 vorgegebene Beleuchtungsrichtung $\vec{k}$ wiedergibt, innerhalb der Pupille 22, 24 in positiver x-Richtung verschoben wird, sodass er an dem Ort der plusersten Beugungsordnung der initialen Beleuchtungswinkelverteilung nach Fig. 9 zu liegen kommt. Es wird also der Beleuchtungshauptstrahl in die Richtung $\vec{k}_{+1} = (1/p, 0)$ verschoben und es wird der Luftbildstapel $i(\vec{x}, z, \vec{k}_{+1})$ gemessen.

Auch hier gilt, dass ein Zentrum des weiteren Pupillenbereichs 19 entsprechend Fig. 11 vom Zentrum des initialen Pupillenbereichs (vgl. Fig. 9) um genau eine Beugungsordnung des Beugungsspektrums 18 beabstandet ist.

Aus einem Vergleich dieser gemessenen Luftbilder $I(\vec{x}, z, \vec{k})$ wird nun der Abbildungsbeitrag des optischen Systems des Metrologiesystems 2, also der Projektionsoptik 17, ermittelt.

Zur Herleitung der bei dieser Ermittlung verwendeten rechnerischen Beziehungen wird zunächst der Abbildungsprozess im optischen System des Metrologiesystems 2 für eine diskrete Beleuchtungsrichtung $\vec{k}$ betrachtet.

Sei $M(\vec{s}, \vec{k})$ das komplexwertige Beugungsspektrum 18 für diese Beleuchtungsrichtung. $\vec{s}$ bezeichnet dabei die auf die Wellenlänge normierte (also dimensionslose) Ortsfrequenz. $\vec{s}$ kann auch als die Richtung der Beugungsordnung bzw. als die x,y-Pupillenkoordinate der Beugungsordnung in der Pupille interpretiert werden.

Die Propagation des Beleuchtungs-/Abbildungslichts 1 durch die Projektionsoptik 17 entspricht einer Multiplikation dieses Spektrums M mit der ebenfalls komplexwertigen Transferfunktion der Projektionsoptik $T(\vec{s}, z)$, die von der Fokuslage des Objekts z abhängt. Es gilt:

$$T(\vec{s}, z) = T(\vec{s})P(\vec{s})e^{2\pi i \frac{z}{\lambda}\sqrt{1-s^2}} \tag{1}$$

P bezeichnet hierbei eine durch die Aperturblende 21 mit numerischer Apertur NA vorgegebene Pupillenfunktion. $P(\vec{s})=1$ innerhalb der NA und $P(\vec{s})=0$ außerhalb der NA.

$T(\vec{s})$ ist die gesuchte Transferfunktion und der letzte Faktor in der obigen Gleichung (1) ist der durch die bekannte Defokussierung des Objektes verursachte Wellenfrontfehler.

Das Beugungsspektrum G an der Austrittspupille 24 der Projektionsoptik 17 (vgl. auch Fig. 6) ist dann:

$$G(\vec{s}, \vec{k}) = M(\vec{s}, \vec{k})T(\vec{s})P(\vec{s})e^{2\pi i \frac{z}{\lambda}\sqrt{1-s^2}} \tag{2}$$

Die daraus resultierende Bildfeldverteilung 27 ist die Fouriertransformierte dieses Beugungsspektrums G. Die Kamera misst deren Intensität I (vgl. beispielhaft die Intensitätsverteilung 29, Fig. 8):

$$I(\vec{x}, z, \vec{k}) = \left| \int M(\vec{s}, \vec{k})T(\vec{s})P(\vec{s})e^{2\pi i \frac{z}{\lambda}\sqrt{1-s^2}} \right|^2 \tag{3}$$

Im Falle eines partiell kohärenten Beleuchtungssystems beinhaltet die Beleuchtung mehrere zueinander inkohärente Beleuchtungsrichtungen. Während des Bestimmungsverfahrens werden mehrere Fokusstaffeln mit gleichen Beleuchtungssettings, aber unterschiedlichen Hauptstrahlrichtungen $\vec{k}_n$ (z.B. $\vec{k}_0$, $\vec{k}_{-1}$, $\vec{k}_1$) aufgenommen. Eine beleuchtungsrichtungsabhängige Gewichtung der Beleuchtungswinkelverteilungen für die Messung n ist $\sigma(k, \vec{k}_n) = \sigma_0(k - \vec{k}_n)$. Summiert über alle Fokusstaffeln, also über alle Beleuchtungssettings ergibt sich:

$$I(\vec{x}, z, \vec{k}_n) = \sum_{\vec{k}} \sigma_0(\vec{k} - \vec{k}_n)I(\vec{x}, z, \vec{k}) = \sum_{\vec{k}} \sigma_0(\vec{q})I(\vec{x}, z, \vec{q} + \vec{k}_n) \tag{4}$$

Hierbei gilt: $\vec{q} = \vec{k} - \vec{k}_n$. Durch Einsetzen der Gleichung (3) in die Gleichung (4) ergibt sich:

$$I(\vec{x}, z, \vec{k}_n) = \sum_{\vec{k}} \sigma_0(\vec{q}) \left| \int M(\vec{s}, \vec{q} + \vec{k}_n)T(\vec{s})P(\vec{s})e^{2\pi i \frac{z}{\lambda}\sqrt{1-s^2}} \right|^2 \tag{5}$$

Nachfolgend werden zwei Näherungen durchgeführt:

1) Zunächst wird angenommen, dass die Verschiebung der Beleuchtungsrichtung lediglich zu einer Verschiebung des Maskenspektrum führt, d.h. $M(\vec{s}, \vec{k}) \approx M(\vec{s} + \vec{k})$. Eine derartige Näherung ist in der Literatur als Hopkinsnäherung bekannt. Bei der Ermittlung des Abbildungsbeitrages des optischen Systems bei den verschiedenen Beleuchtungswinkelverteilungen geht also eine reine Verschiebung des Teststruktur-Beugungsspektrums 18 in der Pupille 22, 24 ein.

2) Es wird ein relativ kohärentes Beleuchtungssetting mit kleinem $\sigma \ll 1$, z.B. $\sigma \leq 0{,}2$. Für die Gewichtung der Beleuchtungswinkelverteilung ergibt sich: $\sigma_0(\vec{q}) = \begin{cases} 1 \ f\ddot{u}r \ q \leq \sigma NA \\ 0 \ f\ddot{u}r \ q > \sigma NA \end{cases}$.

Weiterhin wird angenommen, dass sich die Transferfunktion T der Optik innerhalb des durch $\sigma NA$ definierten Bereiches nur wenig ändert. D.h. wir nehmen an: $T(\vec{s}) \approx T(\vec{s} + \vec{q})$ für $q < \sigma NA$. $\sigma$ kann immer so klein gewählt werden, dass diese Bedingung erfüllt ist. In die Ermittlung des Abbildungsbeitrages geht also die Annahme ein, dass die Transferfunktion T für jede Beleuchtungsrichtung $\vec{k}_n$ innerhalb der jeweils vorgegebenen Beleuchtungswinkelverteilung konstant ist.

Mit diesen Näherungen lässt sich das Luftbild dann wie folgend schreiben:

$$I(\vec{x}, z, \vec{k}_n) = \sum_{\vec{q}} \sigma_0(\vec{q}) \left| \int M(\vec{s} + \vec{q} + \vec{k}_n) T(\vec{s} + \vec{q}) P(\vec{s}) e^{2\pi i \frac{z}{\lambda}\sqrt{1-s^2}} \right|^2 \quad (6)$$

Nun wird noch das als neue Variable das durch das optische System des Metrologiesystems 2, also durch die Projektionsoptik 17, propagierte Spektrum S eingeführt:

$$S(\vec{s}, \vec{k}_n) = M(\vec{s} + \vec{k}_n) T(\vec{s}) \qquad (7)$$

Einsetzen in die Gleichung (6) liefert:

$$I(\vec{x}, z, \vec{k}_n) = \sum_{\vec{q}} \sigma_0(\vec{q}) \left| \int S(\vec{s} + \vec{q}, \vec{k}_n) P(\vec{s}) e^{2\pi i \frac{z}{\lambda}\sqrt{1-s^2}} \right|^2 \qquad (8)$$

Bei der Erfassung der Intensität im Rahmen des Bestimmungsverfahrens wird also das propagierte Spektrum S als Messspektrum erfasst, welches sich als das durch das optische System geführte Beugungsspektrum M der periodischen Teststruktur 5 ergibt. Das Messspektrum S ist ein Produkt aus dem Beugungsspektrum M der periodischen Teststruktur 5 und der Transferfunktion des optischen Systems.
Eine Rekonstruktion des propagierten Spektrums S, die für jede gemessene Beleuchtungsrichtung separat durchgeführt wird, läuft wie folgt ab:

1. Beginne mit einem Spektrum $S(\vec{s}, \vec{k}_n)$, das sich wie vorstehend beschrieben aus den Intensitätsmessungen der Luftbildstapel der verschiedenen Beleuchtungswinkelverteilungen ergibt.

2. Berechne hieraus das Luftbild $I(\vec{x}, z, \vec{k}_n)$ aus der obigen Gleichung (8).

3. Variiere das propagierte Spektrum $S(\vec{s}, \vec{k}_n)$, bis die Differenz zwischen dem im vorstehenden Schritt 2 berechneten Luftbild und den mit der Detektionseinrichtung 25 bei den verschiedenen z-Positionen und den verschiedenen Beleuchtungswinkelverteilungen gemessenen Luftbildern $I_{meas}$ minimal wird, d.h. es wird das Minimierungsproblem gelöst:

$$\min_{S(\vec{s}, \vec{k}_n)} \left| I(\vec{x}, z, \vec{k}_n) - I_{meas}(\vec{x}, z, \vec{k}_n) \right|^2 \qquad (9)$$

Ein ähnlicher Rekonstruktionsschritt wird auch in der DE 10 2019 215 800 A1 beschrieben.
Ergebnis der im letzten Abschnitt beschriebenen Rekonstruktion ist das optimierte propagierte Spektrum $S(\vec{s}, \vec{k}_n)$, d.h. das Produkt aus dem um die Beleuchtungsrichtung verschobenen Maskenspektrum und der Transferfunktion T der Projektionsoptik 17 (vgl. die obige Gleichung (7)).
Nun werden aus den propagierten Spektren ($S$) die beiden Bestandteile (Maskenspektrum $M$ und Transferfunktion $T$) bestimmt. Dazu wird zunächst berücksichtigt, dass die Teststruktur 5 periodisch ist, d.h. das Spektrum besteht aus diskreten Beugungsordnungen mit den Ortsfrequenzen $\frac{l}{p}$ wobei $1 = -\mathrm{Inf}...\mathrm{Inf}$ die ganzzahlige Beugungsordnung ist.

Außerdem wird berücksichtigt, dass die Beleuchtungsrichtungen, also die Beleuchtungswinkelverteilungen, bei denen jeweils die Luftbildmessung stattgefunden hat, jeweils um eine diskrete Anzahl von n-Beugungsordnungen verschoben wurden, nämlich $\vec{k} = (\frac{n}{p}, 0)$ mit n=0,-1,1.

Für die hier betrachteten vertikalen Strukturen gilt also für das Maskenspektrum M:

$$M(\vec{s} + \vec{k}_n) = \sum_{l=-Inf}^{Inf} M_l \delta(s_x + \frac{n}{p} - \frac{l}{p}) \qquad (10)$$

Das Maskenspektrum M, also das Beugungsspektrum 18, ist also eine längs der x-Koordinate äquidistante Kette von Beugungspunkten.

Mit diesen Näherungen kann das rekonstruierte Spektrum S durch Einsetzen in die Gleichung (7) wie folgt geschrieben werden:

$$S(\vec{s}, \vec{k}_n) = \sum_{l=-Inf}^{Inf} M_l \delta \left(s_x + \frac{n}{p} - \frac{l}{p}\right) T(\vec{s}) =$$

$$= \sum_{l=-Inf}^{Inf} M_l \delta(s_x + \frac{n}{p} - \frac{l}{p}) T_{l-n} = \sum_{l'=-Inf}^{Inf} M_{l'} + n \delta(s_x - \frac{l'}{p}) T_{l'} \quad (11)$$

Im Folgenden werden die rekonstruierten Spektren diskretisiert, d.h. es werden nur die Werte am Ort der jeweiligen Beugungsordnungen berücksichtigt. Für die 1-te Beugungsordnung des rekonstruierten Spektrums mit der Verschiebung der Beleuchtungsrichtung um n Beugungsordnungen ergibt sich:

$$S_{n,l} = S\left(s_x = \frac{l}{p}, s_y = 0, k_x = \frac{n}{p}, s_y = 0\right) = T_l M_{n+l} \qquad (12)$$

Dabei ist n=0,-1,1 für die verschiedenen Beleuchtungsrichtungen, bei denen gemessen wurde und 1=-L...L dabei ist L = floor(pNA) die maximale Beugungsordnung innerhalb der NA, im vorliegenden Beispiel also L=1.

Durch Logarithmieren der Formel (12) ergibt sich:

$$\log(S_{n,l}) = \log(T_n M_{n+l}) \qquad (13)$$

$$\log(S_{n,l}) = \log(T_n) + \log(M_{n+l}) \qquad (14)$$

$$s_{n,l} = t_n + m_{n+l} \qquad (15)$$

Mit $s_{n,l} = \log(S_{n,l})$, $t_n = \log(T_n)$ und $m_{n+1} = \log(M_{n+l})$. Die vorherigen Gleichungen (13) bis (15) können auch in Matrixform geschrieben werden:

$$\begin{pmatrix} s_{0,-L} \\ \dots \\ s_{0,L} \\ s_{1,-L} \\ \dots \\ s_{1,L} \\ s_{-1,-L} \\ .. \\ s_{-1,L} \end{pmatrix} = \begin{bmatrix} I_{2L+1} & O_{2L+1} & I_{2L+1} & O_{2L+1} \\ I_{2L+1} & O_{2L+1} & O_{2L+1} & I_{2L+1} \\ I_{2L+1} & I_{2L+1} & O_{2L+1} & O_{2L+1} \end{bmatrix} \begin{pmatrix} t_{-L} \\ \dots \\ t_L \\ m_{-L-l} \\ m_{-L} \\ \dots \\ m_L \\ m_{L+1} \end{pmatrix} \qquad (16)$$

$$\begin{pmatrix} s_{0,-L} \\ \ldots \\ s_{0,L} \\ s_{1,-L} \\ \ldots \\ s_{1,L} \\ s_{-1,-L} \\ .. \\ s_{1,L} \end{pmatrix} = \mathbb{M} \begin{pmatrix} t_{-L} \\ \ldots \\ t_L \\ m_{-L-l} \\ m_{-L} \\ \ldots \\ m_L \\ m_{L+1} \end{pmatrix} \qquad (17)$$

Dabei ist $I_{2L+1}$ die Einheitsmatrix mit (2L+1)x(2L+1) Einträgen und $0_{2L+1}$ ein Spaltennullvektor mit 2L+1 Einträgen. Die Einträge des Vektors auf der linken Seite der Gleichungen (16) und (17) sind die Logarithmen der aus den Messungen bestimmten komplexwertigen propagierten Spektren S. Die Einträge des Vektors auf der rechten Seite sind die gesuchten Logarithmen des Maskenspektrums M und der Transferfunktion T. Diese gesuchten Logarithmen von M und T können aus den Messwerten über die Pseudo-Inverse pinv der Matrix $\mathbb{M}$ bestimmt werden:

$$\begin{pmatrix} t_{-L} \\ \ldots \\ t_L \\ m_{-L-l} \\ m_{-L} \\ \ldots \\ m_L \\ m_{L+1} \end{pmatrix} = pinv(\mathbb{M}) \begin{pmatrix} s_{0,-L} \\ \ldots \\ s_{0,L} \\ s_{1,-L} \\ \ldots \\ s_{1,L} \\ s_{-1,-L} \\ .. \\ s_{1,L} \end{pmatrix} \qquad (18)$$

Nun kann das gesuchte Maskenspektrum M, also das ausschließlich von der Teststruktur 5 hervorgehobene Beugungsspektrum 18 (vgl. Fig. 4) und die Transferfunktion T, also der gesuchte Abbildungsbeitrag des optischen Systems, nämlich der Projektionsoptik 17, an den durch die Beugungsordnung definierten Stützstellen berechnet werden:

$$M\left(s_x = \frac{l}{p}, s_y = 0\right) = e^{m_l} \qquad (19)$$

für l=-L-1...L+1. Diese rekonstruierten Spektren können dann z.B. zur Bestimmung der Maskenphase entsprechend dem verwendet werden, was in der DE 10 2019 215 800 A1 beschrieben ist. Eine Besonderheit des Bestimmungsverfahrens ist, dass auch Beugungsordnungen rekonstruiert werden. die außerhalb der NA liegen (in diesem Fall z.B. die Beugungsordnung L+1 und im konkreten Ausführungsbeispiel die Beugungsordnungen einschließlich der Ordnung +/-2). Durch eine weitere Verschiebung der Beleuchtungsrichtung könnten noch höhere Beugungsordnungen rekonstruiert werden.

$$T\left(s_x = \frac{l}{p}, s_y = 0\right) = e^{t_l} \qquad (20)$$

Für l=-L...L.

Die Transferfunktion T wird also in Amplitude und Phase rekonstruiert.

Die Amplitude der Transferfunktion spiegelt die Apodisierung, die Phase den Wellenfrontfehler wieder. Die Apodisierung sowie der Wellenfrontfehler stellen Beispiele für einen Abbildungs-Qualitätsparameter dar, der aus dem ermittelten Abbildungsbeitrag ermittelt werden kann.

Die Transferfunktion zwischen den Beugungsordnungen kann ggf. durch Interpolation bestimmt werden, sodass der Abbildungsbeitrag auch für Richtungen des Abbildungslichts durch die Projektionsoptik 17 bestimmt wird, die nicht den Richtungen der Beugungsordnungen der Teststruktur 5 entsprechen.

Mit dem bisher diskutierten Beispiel einer Teststruktur 5 mit einer Periode längs einer Koordinate, nämlich längs der x-Koordinate, kann die Transferfunktion T an den Beugungsordnungen auf der x-Achse rekonstruiert werden. Um die Transferfunktion über die ganze Pupille zu bestimmen, kann eine in zwei Dimensionen, also sowohl längs der x- als auch längs der y-Koordinate, periodische Teststruktur 5 eingesetzt werden. Beispiele für eine derart zweidimensional periodische Teststruktur 5 sind 2D periodische Strukturen wie z.B. ein Kontaktlochgitter. Ein derartiges Kontaktlochgitter kann als periodische 2D-Anordnung von Kreisen (Pinholes, Lochblenden) oder Quadraten ausgeführt sein.

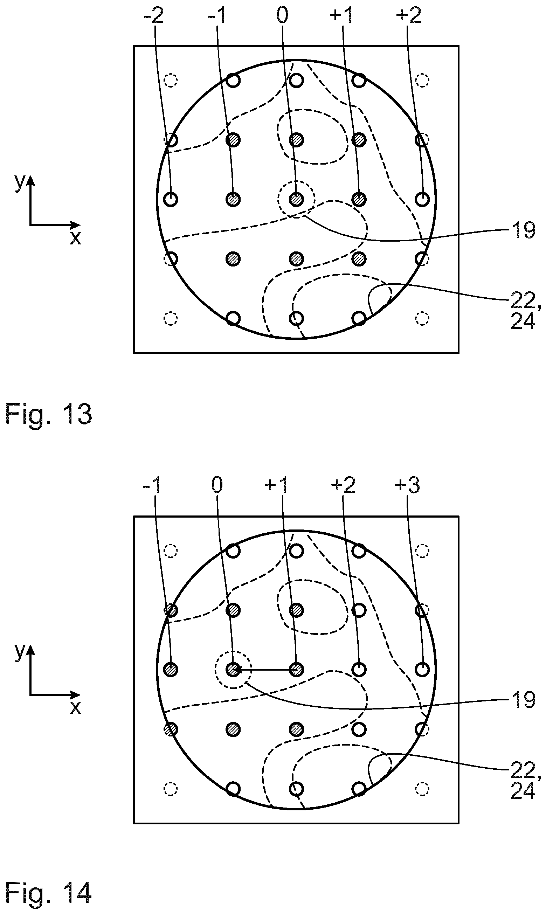

Wie in den Fig. 13 bis 15 dargestellt, verteilen sich die Beugungsordnungen in diesem Fall über die gesamte Pupille 22, 24. Die Beleuchtungsrichtungen werden beim Durchführen des Bestimmungsverfahrens beim Vorgeben der jeweils weiteren Beleuchtungswinkelverteilung in diesem Fall einmal um eine oder mehrere Beugungsordnungen in x- und anschließend um eine oder mehrere Beugungsordnungen in y-Richtung verschoben.

In der Fig. 13 ist wiederum die initiale Beleuchtungswinkelverteilung dargestellt, bei der der Pupillenbereich 19 im Zentrum der Pupille 22, 24 angeordnet ist und somit auch die Beugungsordnung (x=0, y=0), also (0,0). Dargestellt sind in der Fig. 13 auch weitere Beugungsordnungen (x, y) mit -3 $\leq$ x $\leq$ 3 und -2 $\leq$ y $\leq$ 2.

Fig. 14 zeigt die weitere Beleuchtungswinkelverteilung, die durch Verschieben des Pupillenbereichs 19 des Beleuchtungs-/Abbildungslichts 1 über die Vorgabeeinrichtung 10 an den Ort der Beugungsordnung (-1,0).

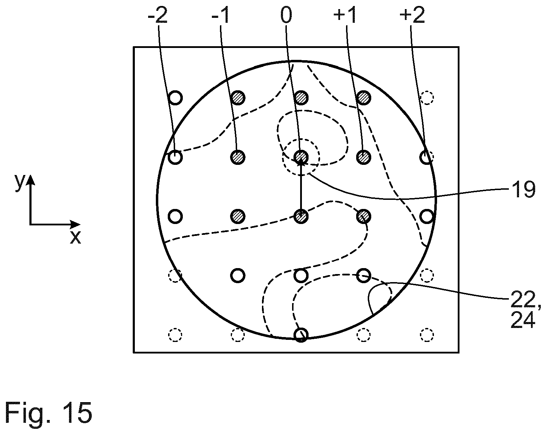

Fig. 15 zeigt die weitere Beleuchtungswinkelverteilung, die entsteht durch Verschiebung des Pupillenbereichs 19 der Beleuchtung durch das Beleuchtungs-/Abbildungslicht 1 über die Vorgabeeinrichtung 10 an den Ort der initialen Beugungsordnung (0,1).

Entsprechend können mit dem oben beschriebenen Verfahren das Maskenspektrum M und die Transferfunktion T zunächst am Ort der Beugungsordnungen (x, y) und durch Interpolation auch zwischen den Beugungsordnungen bestimmt werden.

Die Rekonstruktion erfolgt im Prinzip analog zum 1D Fall. Die durch die Verschiebung in x- und y-Richtung hat die

Matrix $\mathbb{M}$ in den Formeln (16), (17) eine Form mit einer größeren Anzahl von Einträgen.

## Patentansprüche

1. Verfahren zur Bestimmung einer Abbildungsqualität eines optischen Systems bei Beleuchtung mit Beleuchtungslicht (1) innerhalb einer zu vermessenden Pupille (22, 24) des optischen Systems und/oder zur Qualifizierung der Phasenwirkung einer Teststruktur, mit folgenden Schritten:

   - Anordnen einer in mindestens einer Dimension (x; x, y) periodischen Teststruktur (5) in einer Objektebene (4) des optischen Systems,
   - Vorgeben einer initialen Beleuchtungswinkelverteilung ($\vec{k}_0$) zum Beleuchten der Teststruktur (5) mit dem Beleuchtungslicht (1), repräsentiert durch einen zusammenhängenden, ausgeleuchteten initialen Pupillenbereich (19), dessen Fläche kleiner ist als 10 % einer gesamten Pupillenfläche der Pupille (22, 24) des optischen Systems,
   - Beleuchten der Teststruktur (5) mit der vorgegebenen initialen Beleuchtungswinkelverteilung in verschiedenen Abstandspositionen (z) der Teststruktur (5) relativ zur Objektebene (4),
   - Erfassen einer Intensität des mit dem optischen System bei der Abbildung der Teststruktur (5) in jeder Abstandsposition (z) geführten Beleuchtungslichts (1) in einer Bildebene (26) des optischen Systems mit einer ortsauflösenden Detektionseinrichtung (25) zur Bestimmung eines initialen gemessenen Luftbildes ($I(\vec{x}, z, \vec{k}_0)$) der Teststruktur (5),
   - Vorgeben einer weiteren Beleuchtungswinkelverteilung ($\vec{k}_{-1}, \vec{k}_{+1}$) zum Beleuchten der Teststruktur (5) mit dem Beleuchtungslicht (1) repräsentiert durch einen weiteren zusammenhängenden, ausgeleuchteten weiteren Pupillenbereich (19), dessen Fläche kleiner ist als 10 % einer gesamten Pupillenfläche der Pupille (22, 24), wobei der weitere Pupillenbereich (19) nicht mit dem initialen Pupillenbereich (19) überlappt,
   - Beleuchten der Teststruktur (5) mit der vorgegebenen weiteren Beleuchtungswinkelverteilung ($\vec{k}_{-1}, \vec{k}_{+1}$) in verschiedenen Abstandspositionen (z) der Teststruktur (5) relativ zur Objektebene (4),
   - Erfassen einer Intensität des mit dem optischen System bei der Abbildung der Teststruktur (5) in jeder Abstandsposition (z) geführten Beleuchtungslichts (1) in der Bildebene (26) des optischen Systems mit der ortsauflösenden Detektionseinrichtung (25) zur Bestimmung eines weiteren gemessenen Luftbildes ($I(\vec{x}, z, \vec{k}_{-1})$, $I(\vec{x}, z, \vec{k}_{+1})$) der Teststruktur (5),
   - Ermitteln eines Abbildungsbeitrages des optischen Systems aus einem Vergleich der gemessenen Luftbilder,
   - Ermitteln mindestens eines Abbildungs-Qualitätsparameters aus dem gemessenen Abbildungsbeitrag, und/oder
   - Ermitteln eines komplexwertigen Beugungsspektrums der Teststruktur (5) aus dem gemessenen Abbildungsbeitrag

- wobei bei der Erfassung der Intensität ein Messspektrum (S) als durch das optische System geführtes Beugungsspektrum (M) der periodischen Teststruktur (5) erfasst wird,
- wobei ein Zentrum des weiteren Pupillenbereichs (19) von einem Zentrum des initialen Pupillenbereichs (19) um genau eine Beugungsordnung oder um ein ganzzahliges Vielfaches einer Beugungsordnung eines Beugungsspektrums (18) der Teststruktur (5) beabstandet ist.

2. Verfahren nach Anspruch 1, **dadurch gekennzeichnet, dass** die Pupille (22, 24) zumindest angenähert kreisförmig oder elliptisch berandet ist, wobei der Pupillenbereich (19), der die jeweilige Beleuchtungswinkelverteilung repräsentiert, zumindest angenähert werden kann durch einen kreisförmigen oder elliptischen Bereich mit einem Radius, der höchstens 30 % eines Radius der Pupille (22, 24) beträgt.

3. Verfahren nach Anspruch 1 oder 2, **dadurch gekennzeichnet, dass** die Schritte "Vorgeben einer weiteren Beleuchtungswinkelverteilung", "Beleuchten der Teststruktur mit der vorgegebenen weiteren Beleuchtungswinkelverteilung" und "Erfassen einer Intensität" mindestens einmal wiederholt werden.

4. Verfahren nach einem der Ansprüche 1 oder 2, **dadurch gekennzeichnet, dass** das Verfahren mit genau zwei Beleuchtungswinkelverteilungen durchgeführt wird.

5. Verfahren nach Anspruch 4, **dadurch gekennzeichnet, dass** in die Ermittlung des Abbildungsbeitrages bei den verschiedenen Beleuchtungswinkelverteilungen ($\vec{k}$) eine reine Verschiebung des Teststruktur-Beugungsspektrums (M) in der Pupille (22, 24) eingeht.

6. Verfahren nach Anspruch 4 oder 5, **dadurch gekennzeichnet, dass** in das Messspektrum (S) sowohl das Beugungsspektrum (M) der periodischen Teststruktur (5) als auch die Transferfunktion (T) des optischen Systems eingehen, wobei in die Ermittlung des Abbildungsbeitrages die Annahme eingeht, dass die Transferfunktion (T) für jede Beleuchtungsrichtung innerhalb der jeweils vorgegebenen Beleuchtungswinkelverteilung ($\vec{k}$) konstant ist.

7. Verfahren nach einem der Ansprüche 4 bis 6, **dadurch gekennzeichnet, dass** in die Ermittlung des Abbildungsbeitrages eine Rekonstruktion des Messspektrums (S) eingeht.

8. Verfahren nach Anspruch 7, **dadurch gekennzeichnet, dass** bei der Rekonstruktion des Messspektrums (S) eine Differenz zwischen einem gemessenen Luftbild ($I_{meas}$ ($\vec{x}$, z, $\vec{k}$)) und einem vom zu rekonstruierenden Messspektrum (S) abhängigen Luftbild (I($\vec{x}$, z, $\vec{k}$)) minimiert wird.

9. Verfahren nach einem der Ansprüche 1 bis 8, **dadurch gekennzeichnet, dass** bei der Ermittlung des Abbildungsbeitrages eine Rekonstruktion einer Transferfunktion (T) des optischen Systems in Amplitude und Phase erfolgt.

10. Verfahren nach einem der Ansprüche 1 bis 9, **dadurch gekennzeichnet, dass** bei der Ermittlung eines Abbildungsbeitrages zur Bestimmung der Abbildungsqualität eine Rekonstruktion eines Beugungsspektrums der periodischen Teststruktur erfolgt.

11. Verfahren nach einem der Ansprüche 1 bis 10, **dadurch gekennzeichnet, dass** einer der Pupillenbereiche (19) im Zentrum der Pupille (22, 24) liegt.

12. Verfahren nach einem der Ansprüche 1 bis 11, **dadurch gekennzeichnet, dass** die Vorgabe der jeweiligen Beleuchtungswinkelverteilung ($\vec{k}$) durch Positionieren einer Blende in einem Beleuchtungslicht-Strahlengang (12) vor dem optischen System erfolgt.

13. Metrologiesystem (2) zur Durchführung eines Verfahrens nach einem der Ansprüche 1 bis 12

- mit einer Halterung (14) für die Teststruktur (5),
- mit einer Beleuchtungsoptik (9) zur Führung von Beleuchtungslicht (1) hin zu einer von der Halterung (14) vorgegebenen Objektebene (4),
- mit einer Vorgabeeinrichtung (10) zur Vorgabe der Beleuchtungswinkelverteilungen ($\vec{k}$),
- mit dem hinsichtlich seiner Abbildungsqualität zu untersuchenden optischen System (17) und
- mit einer ortsauflösenden Detektionseinrichtung (25) zum Erfassen der Intensität des Beleuchtungslichts (1) in der Bildebene (26)
- wobei die Vorgabeeinrichtung (10) als angetrieben verlagerbare Blende in einem Beleuchtungslicht-Strahlengang (12) vor der Objektebene (4) ausgeführt ist.

**14.** Metrologiesystem nach Anspruch 13, **gekennzeichnet durch** eine Lichtquelle (8) für das Beleuchtungslicht (1).

**Claims**

**1.** Method for determining an imaging quality of an optical system upon illumination with illumination light (1) within a pupil (22, 24) of the optical system to be measured and/or for qualifying the phase effect of a test structure, comprising the following steps:

- arranging a test structure (5) periodic in at least one dimension (x; x, y) in an object plane (4) of the optical system,
- specifying an initial illumination angle distribution ($\vec{k}_0$) for illuminating the test structure (5) with the illumination light (1), represented by a contiguous illuminated initial pupil region (19), the area of which is less than 10% of a total pupil area of the pupil (22, 24) of the optical system,
- illuminating the test structure (5) using the specified initial illumination angle distribution at various distance positions (z) of the test structure (5) relative to the object plane (4),
- detecting an intensity of the illumination light (1) guided using the optical system during the imaging of the test structure (5) in each distance position (z) in an image plane (26) of the optical system using a location-resolving detection device (25) for determining an initial measured aerial image ($I(\vec{x}, z, \vec{k}_0)$) of the test structure (5),
- specifying a further illumination angle distribution ($\vec{k}_{-1}, \vec{k}_{+1}$) for illuminating the test structure (5) with the illumination light (1) represented by a further contiguous illuminated further pupil region (19), the area of which is less than 10% of a total pupil area of the pupil (22, 24), wherein the further pupil region (19) does not overlap with the initial pupil region (19),
- illuminating the test structure (5) with the specified further illumination angle distribution ($\vec{k}_{-1}, \vec{k}_{+1}$) at various distance positions (z) of the test structure (5) relative to the object plane (4),
- detecting an intensity of the illumination light (1) guided using the optical system during the imaging of the test structure (5) at each distance position (z) in the image plane (26) of the optical system using the location-resolving detection device (25) to determine a further measured aerial image ($I(\vec{x}, z, \vec{k}_{-1}), I(\vec{x}, z, \vec{k}_{+1})$) of the test structure (5),
- determining an imaging contribution of the optical system from a comparison of the measured aerial images,
- determining at least one imaging quality parameter from the measured imaging contribution, and/or
- determining a complex-value diffraction spectrum of the test structure (5) from the measured imaging contribution
- wherein upon the detection of the intensity, a measurement spectrum (S) is detected as the diffraction spectrum (M) of the periodic test structure (5) guided through the optical system,
- wherein a centre of the further pupil region (19) is spaced apart from a centre of the initial pupil region (19) by precisely one order of diffraction or by an integer multiple of an order of diffraction of a diffraction spectrum (18) of the test structure (5).

**2.** Method according to Claim 1, **characterized in that** the pupil (22, 24) is at least approximately circularly or elliptically bordered, wherein the pupil region (19) that represents the respective illumination angle distribution can at least be approximated by a circular or elliptical region having a radius which is at most 30% of a radius of the pupil (22, 24).

**3.** Method according to Claim 1 or 2, **characterized in that** the steps "specifying a further illumination angle distribution", "illuminating the test structure with the specified further illumination angle distribution", and "detecting an intensity" are repeated at least once.

**4.** Method according to any one of Claims 1 to 3, **characterized in that** the method is carried out with precisely two illumination angle distributions.

**5.** Method according to Claim 4, **characterized in that** a pure displacement of the test structure diffraction spectrum (M) in the pupil (22, 24) is incorporated in the determination of the imaging contribution at the various illumination angle distributions ($\vec{k}$).

**6.** Method according to Claim 4 or 5, **characterized in that** both the diffraction spectrum (M) of the periodic test structure (5) and the transfer function (T) of the optical system are incorporated in the measurement spectrum (S), wherein the determination of the imaging contribution incorporates the assumption that the transfer function (T) is constant for each illumination direction within the respectively specified illumination angle distribution ($\vec{k}$).

7. Method according to any one of Claims 4 to 6, **characterized in that** a reconstruction of the measurement spectrum (S) is incorporated in the determination of the imaging contribution.

8. Method according to Claim 7, **characterized in that** a difference between a measured aerial image ($I_{meas}(\vec{x}, z, \vec{k})$) and an aerial image dependent on the measurement spectrum (S) to be reconstructed ($I(\vec{x}, z, \vec{k})$) is minimized in the reconstruction of the measurement spectrum (S).

9. Method according to any one of Claims 1 to 8, **characterized in that** a reconstruction of a transfer function (T) of the optical system in amplitude and phase takes place in the determination of the imaging contribution.

10. Method according to any one of Claims 1 to 9, **characterized in that** a reconstruction of a diffraction spectrum of the periodic test structure takes place in the determination of an imaging contribution for determining the imaging quality.

11. Method according to any one of Claims 1 to 10, **characterized in that** one of the pupil regions (19) is in the centre of the pupil (22, 24).

12. Method according to any one of Claims 1 to 11, **characterized in that** the specification of the respective illumination angle distribution ($\vec{k}$) is carried out by positioning a stop in an illumination light beam path (12) in front of the optical system.

13. Metrology system (2) for carrying out a method according to any one of Claims 1 to 12,

   - comprising a mount (14) for the test structure (5),
   - comprising an illumination optical unit (9) for guiding illumination light (1) toward an object plane (4) specified by the mount (14),
   - comprising a specification device (10) for specifying the illumination angle distributions ($\vec{k}$),
   - comprising an optical system (17) to be studied with respect to its imaging quality, and
   - comprising a location-resolving detection device (25) for detecting the intensity of the illumination light (1) in the image plane (26),
   - wherein the specification device (10) is embodied as a driven displaceable stop in an illumination light beam path (12) in front of the object plane (4).

14. Metrology system according to Claim 13, **characterized by** a light source (8) for the illumination light (1).

**Revendications**

1. Procédé permettant de définir une qualité d'image d'un système optique lorsqu'il est éclairé par une lumière d'éclairage (1) à l'intérieur d'une pupille (22, 24) à mesurer du système optique et/ou de qualifier l'effet de phase d'une structure de test, avec les étapes suivantes :

   - agencement d'une structure de test (5) périodique dans au moins une dimension (x ; x, y) dans un plan objet (4) du système optique,
   - spécification d'une répartition angulaire d'éclairage initiale ($\vec{k_0}$) pour éclairer la structure de test (5) avec la lumière d'éclairage (1), représentée par une zone pupillaire initiale (19) contiguë éclairée, dont la surface est inférieure à 10 % d'une surface pupillaire totale de la pupille (22, 24) du système optique,
   - éclairage de la structure de test (5) avec la répartition angulaire d'éclairage initiale spécifiée dans différentes positions de distance (z) de la structure de test (5) par rapport au plan objet (4),
   - détection d'une intensité de la lumière d'éclairage (1) guidée avec le système optique lors l'imagerie de la structure de test (5) dans chaque position de distance (z) dans un plan d'image (26) du système optique avec un dispositif de détection à résolution spatiale (25) pour définir une image aérienne mesurée initiale ($I(\vec{x}, z, \vec{k_0})$) la structure de test (5),
   - spécification d'une autre répartition angulaire d'éclairage ($\vec{k}_{-1}, \vec{k}_{+1}$) pour éclairer la structure de test (5) avec la lumière d'éclairage (1) représentée par une autre zone pupillaire (19) contiguë éclairée, dont la surface est inférieure à 10 % d'une surface pupillaire totale de la pupille (22, 24), l'autre zone pupillaire (19) ne chevauchant pas la zone pupillaire initiale (19),
   - éclairage de la structure de test (5) avec l'autre répartition angulaire d'éclairage spécifiée ($\vec{k}_{-1}, \vec{k}_{+1}$) dans différentes positions de distance (z) de la structure de test (5) par rapport au plan objet (4),

- détection d'une intensité de la lumière d'éclairage (1) guidée avec le système optique pendant l'imagerie de la structure de test (5) dans chaque position de distance (z) dans le plan d'image (26) du système optique avec le dispositif de détection à résolution spatiale (25) pour définir une autre image aérienne mesurée ($I(\vec{x}, z, \vec{k}_{-1})$, $I(\vec{X}, z, \vec{k}_{+1})$) de la structure de test (5),

- détermination d'une contribution d'imagerie du système optique à partir d'une comparaison des images aériennes mesurées,

- détermination d'au moins un paramètre de qualité d'imagerie à partir de la contribution d'imagerie mesurée, et/ou

- détermination d'un spectre de diffraction à valeur complexe de la structure de test (5) à partir de la contribution d'imagerie mesurée

- un spectre de mesure (S) étant détecté en tant que spectre de diffraction (M) de la structure de test périodique (5) guidé par le système optique lors de la détection de l'intensité,

- un centre de l'autre zone pupillaire (19) étant espacé d'un centre de la zone pupillaire initiale (19) d'exactement un ordre de diffraction ou d'un multiple entier d'un ordre de diffraction d'un spectre de diffraction (18) de la structure de test (5).

2. Procédé selon la revendication 1, **caractérisé en ce que** la pupille (22, 24) est encadrée au moins approximativement de manière circulaire ou elliptique, la zone pupillaire (19), qui représente la répartition angulaire d'éclairage respective, pouvant être au moins approximativement approchée par une zone circulaire ou elliptique avec un rayon, qui est égal au maximum à 30 % d'un rayon de la pupille (22, 24).

3. Procédé selon la revendication 1 ou 2, **caractérisé en ce que** les étapes de « spécification d'une autre répartition angulaire d'éclairage », « éclairage de la structure de test avec l'autre répartition angulaire d'éclairage spécifiée » et « détection d'une intensité » sont répétées au moins une fois.

4. Procédé selon l'une des revendications 1 ou 2, **caractérisé en ce que** le procédé est effectué avec exactement deux répartitions angulaires d'éclairage.

5. Procédé selon la revendication 4, **caractérisé en ce que** lors de la détermination de la contribution d'imagerie pour les différentes répartitions angulaires d'éclairage ($\vec{k}$), un décalage pur du spectre de diffraction (M) de la structure de test dans la pupille (22, 24) est intégré.

6. Procédé selon la revendication 4 ou 5, **caractérisé en ce que** tant le spectre de diffraction (M) de la structure de test (5) périodique que la fonction de transfert (T) du système optique sont intégrés dans le spectre de mesure (S), l'hypothèse selon laquelle la fonction de transfert (T) est constante pour chaque direction d'éclairage à l'intérieur de la répartition angulaire d'éclairage ($\vec{k}$) respectivement spécifiée, étant intégrée dans la détermination de la contribution d'imagerie.

7. Procédé selon l'une des revendications 4 à 6, **caractérisé en ce qu'**une reconstruction du spectre de mesure (S) est intégrée dans la détermination de la contribution d'imagerie.

8. Procédé selon la revendication 7, **caractérisé en ce que** lors de la reconstruction du spectre de mesure (S), une différence entre une image aérienne mesurée ($I_{meas}(\vec{x}, z, \vec{k})$) et une image aérienne dépendant du spectre de mesure (S) à reconstruire ($I(\vec{x}, z, \vec{k})$) est minimisée.

9. Procédé selon l'une des revendications 1 à 8, **caractérisé en ce que**, lors de la détermination de la contribution d'imagerie, une reconstruction d'une fonction de transfert (T) du système optique en amplitude et en phase est effectuée.

10. Procédé selon l'une des revendications 1 à 9, **caractérisé en ce qu'**un spectre de diffraction de la structure de test périodique est reconstruit lors de la détermination d'une contribution d'imagerie pour définir la qualité d'image.

11. Procédé selon l'une des revendications 1 à 10, **caractérisé en ce qu'**une des zones pupillaires (19) se trouve au centre de la pupille (22, 24).

12. Procédé selon l'une des revendications 1 à 11, **caractérisé en ce que** la répartition angulaire d'éclairage ($\vec{k}$) respective est spécifiée par le positionnement d'un diaphragme dans une trajectoire de rayons lumineux (12) de lumière d'éclairage en amont du système optique.

13. Système de métrologie (2) destiné à effectuer un procédé selon l'une des revendications 1 à 12

    - avec un support (14) pour la structure de test (5),
    - avec une optique d'éclairage (9) pour guider la lumière d'éclairage (1) vers un plan objet (4) spécifié par le support (14),
    - avec un dispositif de spécification (10) pour spécifier les répartitions angulaires d'éclairage ($\vec{k}$),
    - avec le système optique (17) à examiner en ce qui concerne sa qualité d'image et
    - avec un dispositif de détection à résolution spatiale (25) pour détecter l'intensité de la lumière d'éclairage (1) dans le plan d'image (26)
    - le dispositif de spécification (10) étant réalisé comme un diaphragme pouvant être déplacé de manière entraînée dans une trajectoire de rayons lumineux (12) de lumière d'éclairage en amont du plan objet (4).

14. Système de métrologie selon la revendication 13, **caractérisé par** une source de lumière (8) pour la lumière d'éclairage (1).

Fig. 1

Fig. 2

Fig. 3

Fig. 4

Fig. 5

Fig. 6

Fig. 7

Fig. 8

Fig. 9

-2    -1    0    +1    +2    +3    +4

19

22, 24

Fig. 10

-4    -3    -2    -1    0    +1    +2

19

22, 24

Fig. 11

Fig. 12

Fig. 13

Fig. 14

Fig. 15

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102019215800 A1
- WO 2016012426 A1
- DE 102013219524 A1
- DE 102017216703 A1
- DE 102018211895 A1
- DE 10317366 A1
- WO 2015044362 A1

- US 20190391087 A1
- WO 2008025433 A2
- WO 2017207297 A1
- DE 102016218977 A
- US 20130063716 A1
- DE 10220815 A1
- DE 10220816 A1
- US 20130083321 A1

**In der Beschreibung aufgeführte Nicht-Patentliteratur**

- **MARTIN et al.** A new system for a wafer lever CD metrology on photomasks, proceedings of SPIE. The International Society for Optical Engineering, 2009, 7272